# EUROPEAN PATENT SPECIFICATION

(11) **EP 1 537 258 B1**
(45) Date of publication and mention of the grant of the patent: **15.08.2007**
(21) Application number: 03763891.3
(22) Date of filing: 16.07.2003
(51) Int. Cl.: C30B 33/00, H01L 21/00

(54) **METHOD OF FABRICATING SUBSTRATES, IN PARTICULAR FOR OPTICS, ELECTRONICS OR OPTOELECTRONICS----------------------------------------**
VERFAHREN ZUR HERSTELLUNG VON SUBSTRATEN, INSBESONDERE FÜR DIE OPTIK, ELEKTRONIK UND OPTOELEKTRONIK
PROCEDE DE FABRICATION DE SUBSTRATS, EN PARTICULIER POUR L'OPTIQUE, L'ELECTRONIQUE OU L'OPTOELECTRONIQUE

(30) Priority: 17.07.2002 FR 0209021; 09.04.2003 US 461504 P
(43) Date of publication of application: 08.06.2005
(73) Proprietor: S.O.I.Tec Silicon on Insulator Technologies, 38190 Bernin (FR)
(72) Inventor: GHYSELEN, Bruno, F-38170 Seyssinet-Pariset (FR); LETERTRE, Fabrice, F-38000 Grenoble (FR)
(74) Representative: Bomer, Françoise Marie
(86) International application number: PCT/EP2003/007854
(87) International publication number: WO 2004/007816

(56) References cited:
- EP-A- 0 610 563
- WO-A-00/61841
- WO-A-01/75196
- WO-A-99/41779
- FR-A- 2 681 472
- FR-A- 2 774 510
- US-A- 5 877 070
- PATENT ABSTRACTS OF JAPAN vol. 1998, no. 09, 31 July 1998 (1998-07-31) & JP 10 093122 A (NIPPON TELEGR &TELEPH CORP <NTT>), 10 April 1998 (1998-04-10) cited in the application
- WELDON M K ET AL: "Mechanism of silicon exfoliation by hydrogen implantation and He, Li and Si co-implantation YSOI technology" SOI CONFERENCE, 1997. PROCEEDINGS., 1997 IEEE INTERNATIONAL FISH CAMP, CA, USA 6-9 OCT. 1997, NEW YORK, NY, USA,IEEE, US, 6 October 1997 (1997-10-06), pages 124-125, XP010256236 ISBN: 0-7803-3938-X

## Description

The invention relates to a method of fabricating substrates, in particular for optics, electronics or optoelectronics.

The starting materials used in fabricating said substrates can be obtained industrially, for example in the form of ingots of raw material.

In the case of monocrystalline silicon, for example, those ingots are obtained using CZOCHALSKI pulling (CZ pulling) method from a bath of fused silicon or using zone melting (ZM pulling) method from a polycrystalline ingot.

Monocrystalline silicon carbide is fabricated, for example, by means of a sublimation method that is well known to the skilled person.

Such growth methods produce ingots that are generally cylindrical in shape with two substantially conical ends. Depending on the nature of the material constituting the ingot, it may be from about ten centimeters long (for silicon carbide, for example) up to about 2 meters long (for silicon).

Those ingots are then cut into slices perpendicular to the longitudinal axis of the cylinder to form later wafers of starting material that are then used in a variety of applications. Those wafers are only a few hundred micrometers (µm) thick (as an example, 200 millimeter (mm) diameter silicon wafers of standard fabrication are 725 µm thick).

In more detail, the steps for fabricating such wafers consist of trimming the two pointed ends of the ingot, grinding and turning its irregular lateral surface to obtain a cylinder of perfectly circular cross section, then cutting it into slices using a circular saw or a wire saw, for example.

The rondelles or slices obtained then undergo a finishing step consisting of grinding them to obtain a wafer with a uniform thickness, then polishing at least one of its two opposite faces to obtain a perfectly flat surface. Finally, each wafer is immersed in a series of chemical baths to eliminate the dust and particles that still subsist on the two faces and which could be a source of subsequent pollution.

An example of such an ingot machining method is disclosed in the European Patent Application EP 0 610 563.

The above-mentioned steps are extremely expensive both as regards the cost of the equipment used to carry out the machining or treatments, and as regards the time taken to carry them out and the loss of starting material on cutting.

By way of example, when a 300 µm thick wafer is to be produced, about 400 µm of material is lost in forming that wafer. Thus, for an ingot length of 1 cm, i.e., 10000 µm, it is only possible to produce fourteen wafers (fourteen times 700 µm).

Further, with certain extremely hard, fragile and brittle materials such as silicon carbide, the above-mentioned preparation steps can prove to be extremely long and tedious as the product takes a long time to polish and chemical attack is difficult.

Further, sometimes the massive wafers obtained merely constitute an intermediate product. In certain methods of removing and transferring thin layers, for example a method such as that described in French patent FR-A-2 681 472, only the front face of the wafer acts as a base for removing material and thus only the front face must be rigorously flat. In contrast, it is pointless to subject the rear face of the wafer and the cylindrical lateral face to polishing and finishing that is expensive both as regards time and starting material.

Finally, the document "Patent Abstracts of Japan", vol. 1998, n° 9 of the Japanese Patent Application JP 10 093122 describes a manufacture method of a thin film solar cell. According to said method a silicium substrate, made from a single crystal or very large grain size type polycrystalline ingot or wafer is implanted with hydrogen ions, then a second substrate is adhered onto it and after a suitable heat treatment is used to peel a silicium thin film from said substrate.

Nevertheless, such a transferring-method is applied to a substrate and not to a raw ingot the general from of which can vary.

The aim of invention is to overcome the disadvantages described above and in particular, substantially to reduce the loss of starting material from the materials used in producing the substrates, in order to reduce fabrication costs.

The invention also aims to simplify and limit the machining steps carried out on the starting ingot to as great an extent as possible.

This aim is achieved by a method of fabricating substrates, in particular for optics, electronics, or optoelectronics, by transferring a layer of a material suitable for said type of application, and in particular a semiconductor material, onto a support.

Said method is characterized in that it comprises the following steps:
a) carrying out an operation to form a flat face termed the "front face" on a raw ingot of material intended to form said layer, without - or substantially without - lapping the lateral surface of said ingot;
b) implanting atomic species beneath said front face of the ingot to a controlled mean implantation depth to create a zone of weakness located close to said implantation depth and defining a top layer of said ingot;
c) bonding a support to said front face;
d) directly detaching from the ingot, at the zone of weakness, the portion of said top layer which is bonded to said support, to form said substrate; and.
e) re-commencing the cycle of said operations from step b) at least once.

The invention means that the intermediate steps in fabricating massive wafers and the associated loss of material can be eliminated.

The method of the invention also comprises the following advantageous characteristics, taken alone or in combination:
- the raw ingot has the shape of a cylinder with an axis of revolution X-X' and in that the flat front face (13) is substantially perpendicular to said axis X-X';
- the support has at least a portion of its outline inscribed within the outline of the front face of the raw ingot;
- the outline of the face of the support which comes into contact with the front face of the raw ingot is inscribed within the outline of said front face;
- it comprises a step of finishing the top layer from which the portion bonded to said support has been removed, said finishing step being carried out occasionally or systematically after step d) and before recommencing step b) of a subsequent cycle of operations and consisting of eliminating the ring of material of the top layer that has not been transferred to the support, to obtain a new front face that can be bonded to a new support;
- the operation of forming the front face comprises an operation for cutting and lapping the ingot;
- the implantation operation is carried out at high energy so that the portion of the top layer transferred onto said support has sufficient thickness to be self-supporting;
- said support comprises at least one layer of a monocrystalline or polycrystalline material selected from silicon, silicon carbide, indium phosphide, gallium arsenide and germanium;
- said support is constituted by a plastic and/or flexible material;
- said support is a gripping tool;
- bonding to the support is accomplished by molecular adhesion, eutectic bonding, by applying an adhesive, by applying a wax, by applying electrostatic forces, or by applying a pressure differential;
- bonding of the support is definitive or, on the contrary, temporary;
- the operation for detaching the layer of material from the remainder of the ingot is accomplished using at least one of the following techniques that can be used alone or in combination: applying stresses of mechanical or electrical origin, supplying heat energy, or a chemical etching operation;
- the material of the ingot is monocrystalline and is selected from silicon carbide, silicon, indium phosphide, gallium arsenide, and germanium;
- said support and/or said ingot include(s) a layer of an insulator, in particular an oxide or a nitride;
- during step a), said raw ingot is cut into at least one thick segment, said front face being produced on said thick segment.

The invention relates to a method of fabricating a substrate. Throughout the remainder of the description and claims, it should be understood that the term "substrate" means an assembly generally comprising a support covered with a layer of a material originating from an ingot, said support being bonded to said layer of material in a definitive manner or merely in a temporary manner.

Regarding said material originating from an ingot, the invention more particularly applies to expensive materials such as monocrystalline materials or materials obtained by slowly pulling the ingot under optimal conditions for producing a low density of defects.

The invention is also applicable to extremely hard materials for which machining and polishing are lengthy and difficult procedures.

Two examples of materials for which the invention is particularly suitable are monocrystalline silicon carbide because of its hardness, and monocrystalline silicon, since this is by far the most widely used material in the micro-electronics field.

Regarding silicon, ingots obtained by CZ pulling (CZOCHALSKI) or by any other technique aimed at obtaining best quality monocrystalline silicon can be used. Examples that can be mentioned are COPs type (Crystal Originated Particles) low defect density ingots or those that are less sensitive to the formation of oxygen precipitates. FZ type ingots or other qualities of silicon corresponding to "perfect silicon" type commercially available ingots are also concerned. It is also possible to use silicon ingots that have undergone a treatment aimed at reducing their defect density, for example heat treatment in hydrogen, which is well known to the skilled person.

It is also possible to mention the following as examples of other monocrystalline materials that can be transferred onto the support: indium phosphide, gallium arsenide and germanium.

It should also be understood that the term "ingot" means a mass of raw material the general form of which can vary. The ingot may be generally cylindrical in shape with two substantially conical ends, or it may be elongate, tubular, with a non-circular cross section, for example square, hexagonal, or octagonal, with two pointed ends or not, or it may be broadly spherical (known to the skilled person as a "boule"), or it may even be in the form of a cube.

Further, it should be understood that the method of the invention is also applicable to thick segments taken from said ingot. When the ingot is elongate in shape, said thick segments can be cut substantially transversally or, in contrast, longitudinally.

Other aspects, aims and advantages of the invention become clear on reading the following detailed description. The invention will be better understood from the references made to the accompanying drawings, in which:
- Figures 1 to 4, 7 and 8 are diagrammatic representations of the different steps employed in an implementation of the method of the invention;
- Figures 5 and 6 are diagrammatic top views illustrating different variant implementations of the invention.

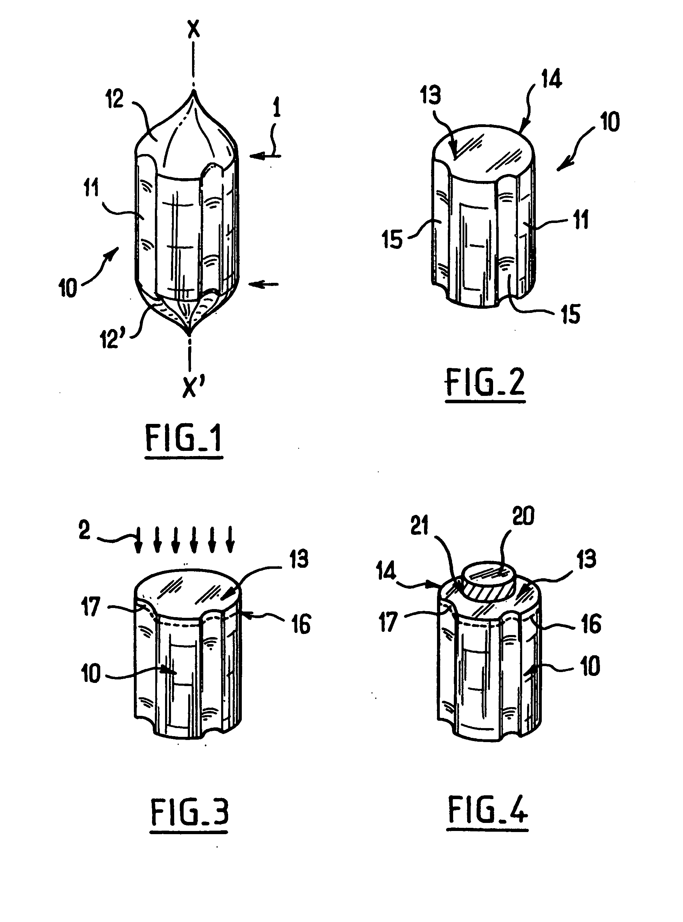

As can be seen in Figure 1, the starting product is an ingot 10 approximately in the shape of a cylinder with an axis of revolution X-X', the lateral surface 11 of which is typically definitely not geometrically regular; in particular, top and bottom end regions 12 and 12' (relative to said axis X-X') are not flat and may even be conical.

One of said end regions 12 undergoes treatment for forming a flat face 13 termed the "front face". This treatment consists firstly in sawing or cutting said end 12, then in lapping and polishing the flat face 13 obtained (general reference number 1 in Figure 1).

Advantageously, before or after the step of finishing polishing face 13, it is possible for the face to undergo chemical etching treatment to eliminate the zone that has been damaged during the mechanical material removal steps. It should be noted, however, that it is not necessary to machine the bottom end 12' to implement the invention.

An ingot 10 is obtained that has said flat face 13 on a plane that is substantially perpendicular to axis X-X' of the ingot, although this is not obligatory, and of outline 14 that is generally irregular.

Ingot 10 can, for example, have defects 15 on its lateral surface (see Figure 2). Further, depending on the method used for fabricating ingot 10, it may have a useful central core, for example monocrystalline in nature, surrounded laterally by a gangue of unusable polycrystalline material that is about 1 mm to 2 mm thick.

By dint of the method of the invention, no more - or substantially no more - lapping of the lateral surface 11 or of the polycrystalline gangue is carried out before transferring the layer. The expression "substantially no more" means that it is possible to carry out a very small amount of lapping of the lateral surface 11 but with tolerances in the diameter that are much higher than those normally tolerated during wafer production.

By way of illustrative example, a 50 mm diameter silicon carbide ingot measures no more than 10 centimeters (cm) in length, while a 200 mm diameter silicon ingot can be as much as 1.50 meters (m) to 2 m long.

As a result, after said machining operations (trimming the tip 12 and polishing the front face 13), a silicon carbide ingot will generally be used as such in the method of the invention, while a silicon ingot will advantageously be cut into segments about 5 cm to 50 cm in length to facilitate handling. Nevertheless, cutting off said segments (termed "thick segments" in the remainder of the description and claims) results in proportionally low material losses that are not on the same scale as the material losses caused in the prior art during fabrication of wafers that are only a few hundreds of micrometers thick.

Subsequently, an operation 2 for implanting atomic species (typically hydrogen gas ions or a mixture of hydrogen and helium gas ions) is carried out on the front face 13 of the ingot (Figure 3). This operation creates a zone of weakness 16 in the material so that the top layer 17 of the ingot can subsequently be detached from the remainder of the ingot 10, which layer extends between said zone of weakness 16 and the front face 13 of the ingot.

The term "implanting atomic species" means any bombardment of atomic, molecular or ionic species, which is capable of introducing said species into a material with a maximum concentration of said species at a predetermined depth with respect to the bombarded surface. The species are introduced into the material with an energy that is also distributed about a maximum. Implantation can be carried out using an ion beam implanter, a plasma immersion implanter, etc..

Implantation doses are advantageously of the order of 10¹⁶ to 10¹⁸ ions/cm². Implantation energies can advantageously vary from a few tens of keV to at most one MeV, which results in an implantation depth, and thus in a thickness of the top layer 17, which can be from a few tenths to a few tens of micrometers.

High energy implantation (of the order of at least 1 megaelectronvolt (MeV) can produce a layer 17 with a thickness of at least 50 µm, sufficient for it to then be self-supporting. Conversely, low energy implantation (i.e., less than 1 MeV) produces a thinner top layer 17 which must be permanently attached to a support.

The implantation conditions will be selected by the skilled person as a function of the nature of the material and the envisaged applications and in general, the manner by which subsequent detachment along the zone of weakness 16 can be achieved with a minimum of effort.

A support 20 is then bonded to the front surface 13 of ingot 10 (Figure 4).

The support 20 can comprise a single layer of material or, in contrast, a plurality of superimposed layers. Examples that can be mentioned are monocrystalline or polycrystalline materials such as silicon, silicon carbide (SiC), indium phosphide (InP), gallium arsenide (AsGa) and germanium (Ge).

Support 20 can also comprise an insulating layer such as a layer of oxide (for example SiO₂) or nitride (for example Si₃N₄).

Support 20 can also be a gripping tool of the type comprising a boss with a particular shape that is known to the skilled person.

Finally, said support 20 can be constituted by a plastic and/or flexible material such as a strip of plastic material or polymer or a strip of paper.

Its thickness is advantageously selected to allow an optional slight deformation by bending to facilitate its bonding to ingot 10. Further, its dimensions and shape will be selected as a function of the envisaged applications and in this particular case in which the ingot 10 has an unusable peripheral gangue, the dimensions of the support 20 will be selected so that only useful material at the center of the ingot is removed.

Bonding can be definitive or temporary depending on the final envisaged applications and on the nature and cost of the materials used for the support 20 or the ingot 10. The skilled person will select the most appropriate technique.

A variety of definitive bonding techniques is described below. Temporary bonding techniques are discussed below when describing the step for detaching support 20.

Bonding can be carried out by "direct bonding" or "molecular adhesion bonding", i.e., a technique that is known to the skilled person as "wafer bonding" or "direct bonding", in which no adhesive is used. Such techniques, however, require the surfaces which are to be brought into contact to be perfectly flat and polished.

That type of bonding is generally used in an extremely clean environment and thus is well suited among others for silicon ingots.

Bonding can also be accomplished by anodic bonding. That type of bonding is suitable among others for a silicon carbide type material as it does not require the degree of cleanliness of the surfaces and removal of the contaminants required of the direct bonding technique described above.

In a manner that is known to the skilled person, bonding can also be accomplished using an adhesive, a wax, or eutectic bonding.

Bonding can also be accomplished by applying or forming oxides (for example SiO₂) or nitrides (for example Si₃N₄) on the surfaces of the ingot 10 and/or the support 20 to be brought into contact. That type of bonding will be used when an insulating substrate is to be produced subsequently. In contrast, it is possible to use an intermediate bonding layer formed from a refractory material to obtain a substrate with a conductive nature.

These bonding techniques have been described in the document "Semiconductor Wafer Bonding", Science and Technology, by Q.Y. Tong and U. Gösele, Wiley Interscience Publications.

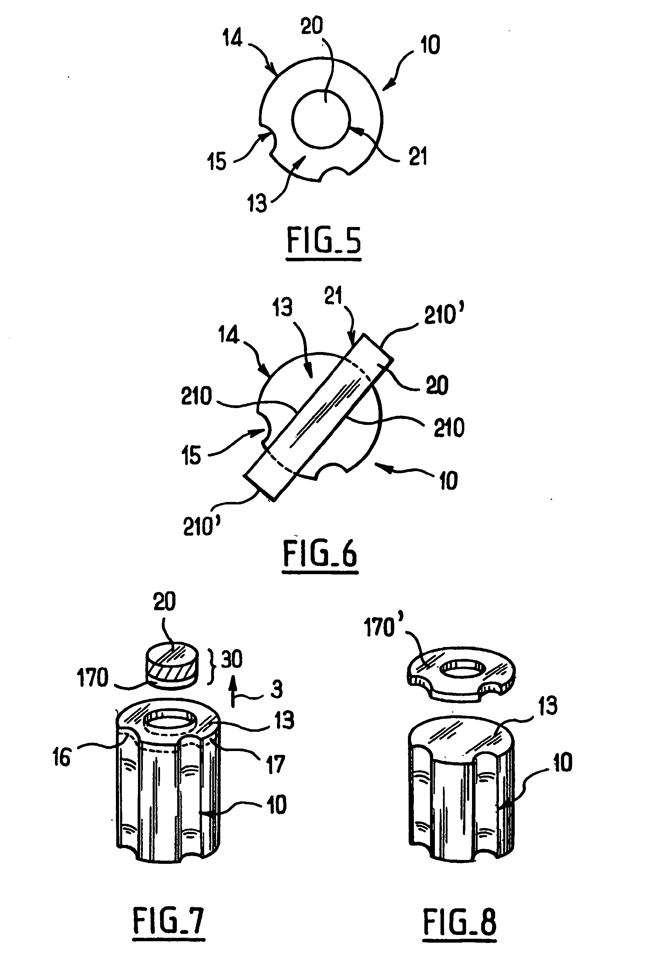

In accordance with a first variation shown in Figure 5, the outline 21 of the face of the support 20 which comes into contact with the front face 13 of the ingot 10 is inscribed within the outline 14 of said front face 13. This circular support 20 could also be square, rectangular or of any shape provided that it is inscribed within the outline 14. Thus, it is not necessary to grind the ingot 10 to diameter.

In a second variation shown in Figure 6, only a portion of the outline 21 of the face of the support 20 which comes into contact with the front face 13 is inscribed within the outline 14 of said front face 13.

By way of example, this support 20 can be rectangular and its length greater than the diameter of the ingot 10. The outline 21 is divided into two portions, a first portion 210 of the outline which is inscribed within the outline 14 of the front face 13 of the ingot 10 (in this case two parallel lines) and a second portion 210' of the outline which is located outside said outline 14 (in this case the two U-shaped ends of the rectangular support 20).

An operation 3 is then carried out for detaching a portion 170 of the top layer 17 of the ingot which is bonded to the support 20 (see Figure 7).

This operation is carried out by applying to said support 20 an action that can cause said portion 170 to detach at the zone of weakness 16.

Detachment is accomplished by at least one of the following techniques that can be used alone or in combination: application of mechanical stresses (shear, tension, compression, ultrasound, moving the support away from the ingot, etc.), or stresses originating from electrical energy (application of an electrostatic or electromagnetic field), or supplying heat energy (radiation, convection, conduction, increasing the pressure in the microcavities), etc.

Heat energy can be derived from applying an electromagnetic field, an electron beam, thermoelectric heating, a cryogenic fluid, a supercooled liquid, etc.

Detachment can also be accomplished by applying a chemical treatment such as a chemical etching operation, for example, in a manner that is known to the skilled person, an etching operation using a chemical solution that attacks and specifically destroys the implanted zone.

Detachment can also be accomplished by combining a plurality of the detachment techniques mentioned above.

Figure 7 shows that the portion 170 of the top layer 17 is removed from the ingot 10 and is thereby automatically cut to size (i.e., self-defined) to the outline of the support 20 (circular in Figures 4 and 5), which can in particular, prior to the set of operations mentioned above, avoid the need to cut the lateral peripheral surface 11 of the ingot 10 to adapt it to the shape of the support, with its concomitant disadvantages, as mentioned in the introduction.

In the frequent case in which the support 20 has a circular outline, the step of grinding the ingot "to diameter" is superfluous, i.e., the step consisting of machining a perfectly cylindrical ingot is superfluous.

When the support 20 has an outline 21 that in part exceeds that of the ingot 10 (see Figure 6), the top layer of the ingot 10 is withdrawn from the remainder of said ingot and is thereby automatically self-defined at portion 210 of the outline 21, inscribed within the outline 14 and grinding the ingot to diameter is also unnecessary.

A substrate 30 constituted by the self-defined layer 170 bonded to the support 20 is then obtained.

Some of the definitive bonding techniques mentioned above, such as wafer bonding, eutectic bonding, or adhesive or wax bonding can become temporary bonding techniques by applying a subsequent treatment (chemical treatment, heating, etc ...) which allows the support 20 to be detached from the layer 170, for example to transfer the latter to another support or substrate.

It should also be noted that when the support 20 is a gripping tool, bonding is carried out by applying a pressure differential (suction) or by using electrostatic forces, and those techniques are also temporary bonding techniques.

A simple finishing treatment can then be carried out to eliminate the ring of material 170' when it exists, this ring remaining on the surface of the ingot 10 after the thin layer 170 has been removed by using the support 20 (see Figure 8).

The term "ring" 170' should be considered in its broad sense as meaning any residue of the top layer 17 which remains after removing the thin layer 170, this ring possibly being of any non-annular shape and it can also be in the form of a simple blistered film.

Depending on the implantation energy of the atomic species and thus on the thickness of the thin layer 170 and the ring 170', this finishing treatment can be carried out by light polishing, simple brushing, or by applying heat energy. This finishing step is intended to render the front face 13 capable of being bonded to a new support 20. It should be noted, however, that this finishing step is not always necessary and the skilled person will elect to carry it out systematically or otherwise before recommencing a cycle of the layer-removal steps.

The steps illustrated in Figures 3, 4, 7 and optionally 8 can be repeated several times if it is wished until ingot 10 is exhausted.

Some examples of implementations of the method of the invention are described below.

However, the invention is not limited to these examples. It is generally applicable to ingots of materials used to produce substrates in the optics, electronics and optoelectronics fields, in particular semiconductor materials.

### EXAMPLE 1

A monocrystalline silicon carbide ingot 10 was used. Its periphery had a polycrystalline gangue inherent to the growth method employed. The ingot had a diameter of about 60 mm and a length of the order of 50 mm. Depending on the envisaged applications, the ingot could be of polytype 4H or 6H, using the denominations employed by the skilled person.

It then underwent cutting and lapping operations illustrated in Figure 2, accompanied by a polishing finishing step.

Preferably, prior to the polishing finishing step, a chemical attack step was carried out with the aim of removing a zone damaged during the mechanical material removal steps. Typically, 10 µm of material was removed during this chemical attack step.

Depending on the polytype, the surface 13 of the ingot will be selected to be substantially parallel to a crystallographic plane (polytype 6H, on-axis) or deliberately out of orientation by a few degrees (as is routine in the case of polytype 4H, for example by 8°, termed "8° off-axis"). This implies an operation for determining the corresponding crystallographic planes.

Operation 2 for implanting atomic species was then carried out (see Figure 3). In this example, the atomic species were H⁺ ions. They were implanted with an energy of 200 kiloelectronvolts (keV) to define a top layer 17 that was more than 1 µm thick. An implantation dose of the order of 8 x 10¹⁶ H⁺/cm² was used.

A polycrystalline silicon carbide support 20 obtained by CVD (chemical vapor decomposition) with a thickness of 200 µm coated with a 1 µm thick layer of SiO₂ was bonded to the front surface 13 of the ingot, the SiO₂ layer being in contact with said ingot. This support was 50 mm in diameter and was positioned substantially centrally with respect to the front face 13.

Bonding was carried out by direct bonding or wafer bonding (see the above-cited book by Gosele). Advantageously, just prior to bonding, each of the surfaces to be brought into contact was cleaned and slightly polished, thereby removing a thickness of only a few tenths of a nanometer during polishing.

Detachment along the zone of weakness 16 was carried out at 900°C for 2 hours. During detachment, a disk 170 with a diameter that substantially corresponded to the diameter of the support 20 (i.e., about 50 mm) was removed from ingot 10 and transferred to said support. There remained on ingot 10 a complementary annular ring 170', as shown in Figure 7, with a width of about 5 mm.

The assembly constituted by support 20, the layer 170 of monocrystalline SiC removed from ingot 10 and the intermediate layer of SiO₂ then underwent a series of finishing steps. These were carried out with the manifold aim of regaining the roughness and layer qualities of the monocrystalline SiC layer of a monocrystalline substrate, but also to strengthen the bonding interface. The finishing steps include heat treatments, which were oxidizing or non-oxidizing, chemical etching steps and finishing polishing steps.

Further, as shown in Figure 8, the ingot 10 then underwent a finishing step to produce an ingot that is similar to that of Figure 2, with the exception that it is a little shorter. The finishing steps could comprise heat treatment steps, chemical etching steps and polishing steps. In the case, for example, in which polishing is the finishing step, it should be noted that the material removed during said finishing polishing is significantly less than that corresponding to the lapping and polishing steps used during preliminary preparation of the ingot with a view to preparing the surface 13 for the first removal of the layer, using the method described above. If the removed thickness is of the order of 1.5 µm, a finishing step corresponding to removing 3 µm of material will be amply sufficient.

The different steps of the method just described were then repeated a large number of times, the theoretical limit to the number of removal steps corresponding to the complete exhaustion of the entire mass of ingot 10. In practice, this cycle will be stopped before the remaining thickness becomes too short, no longer guaranteeing that the remainder of the ingot is rigid. Thicknesses less than 200 µm are reasonable limits in this respect.

### EXAMPLE 2

This example reproduced Example 1, but differed in that the ingot 10 was an ingot of monocrystalline silicon. This ingot had a diameter of slightly more than 300 mm, about 310 mm, a <100> crystallographic orientation and a length of 1.20 m, ignoring the conical ends. It could be obtained using any known technique such as CZ (CZOCHALSKI) pulling.

As shown in Figure 2, this ingot 10 also underwent a cutting operation aimed at removing the conical ends 12, 12', and also underwent a turning operation to form a circular cylinder with a diameter of about 300 mm, with a diameter tolerance that was greater than the normal standards fixing tolerances for the diameter of substrates. A diameter of 302 mm ± 1 mm, and thus slightly irregular, was obtained.

Further, in contrast to the preceding example, this ingot 10 also underwent segmenting to define six segments of ingot each with a length of the order of 20 cm. Each ingot segment was then lapped, its ends were polished to obtain six segments that were equivalent to that of Figure 2. Finally, a chemical etching step was interposed just prior to final polishing with the aim of removing 80 µm of silicon that could correspond to a zone damaged by lapping or cutting.

Again, implantation was carried out with H⁺ ions at an energy of 200 keV to define a 1.5 µm thick top layer 17. An implantation dose of the order of 8 × 10¹⁶ H⁺/cm² was used.

Support 20 in this example was a 300 mm CZ type silicon substrate thermally oxidized on its surface to form a 0.4 µm thick oxide layer. The presence of this thermal oxide corresponded here to the need to produce a silicon on insulator structure, ("SOI" type structure).

Bonding was by direct bonding or wafer bonding (see the above-cited book by Gösele). Just prior to bonding, each of the surfaces that was to be brought into contact was cleaned using one of the techniques known to the skilled person.

Detachment along the implanted zone was accomplished by applying a heat treatment carried out at 500°C for 2 hours. During detachment, a disk the diameter of which substantially corresponded to the diameter of the support (i.e., about 300 mm) was removed from the ingot and transferred to the support 20. A complementary ring then remained on the ingot as shown in Figure 7, of the order of a few millimeters wide depending on the exact diameter of the ingot and the more or less rounded shape of the edges of support 20.

A 300 mm diameter SOI type structure was obtained characterized by a silicon thickness of 1.5 µm over a thickness of 0.4 µm of insulator in the form of SiO₂.

In order to increase productivity, applying this method to both ends of the segment was envisaged. Each of the two ends was successively or concomitantly implanted, bonded to a support substrate 20 and underwent a detachment and finishing step for each new cycle.

### EXAMPLE 3

Example 3 reproduces Example 2 but the ingot 10 was cut into twenty-four segments each with a thickness of the order of 50 mm.

In this example, it can be seen that the loss of material linked to the cutting, grinding and polishing operations was higher than in Example 2 in which only six segments were cut. In contrast, more segments were obtained on which it was possible to operate in parallel.

### EXAMPLE 4

This example reproduced Example 3 but differed in that the support 20 acted as a temporary support rather than in Example 3 in which the support 20 was permanently and definitively bonded.

For implantation, H⁺ type atomic species were used. The implantation parameters were an energy of 500 keV and a dose of 1.2 x 10¹⁷ H⁺/cm². Under these conditions, the thickness of the removed layer 17 was about 4 µm to 5 µm.

Bonding between the support 20, again constituted by a 300 mm diameter CZ silicon wafer coated with a layer of thermal oxide, and the front face 13 of the ingot 10 was accomplished by dint of a reversible adhesive or a reversible wax with a relatively low melting temperature. Typically, a wax with a melting temperature in the range 70°C to 120°C was used. Such waxes are known to the skilled person.

Detachment differed in this example in that it was carried out at ambient temperature by applying mechanical forces aimed at spacing the support substrate 20 from the remainder of the ingot, forced detachment being carried out along the interface that had been weakened by implantation. One means of applying these mechanical stresses consisted, for example, of inserting a blade or a jet of air or pressurized water into the gap formed at the junction between the face 13 and support 20.

Advantageously, an initial heat treatment could have been carried out prior to applying the wax with the aim of encouraging the weakened state, in particular by the growth of micro-cavities in the implanted zone 16. A temperature of the order of 450°C is recommended.

After detachment, the layer 17 bonded to the support 20 by the wax layer was brought into intimate contact using a direct bonding technique with a second 300 mm diameter support formed from silicon, for example. This second bonding could be encouraged by light polishing, typically removing 0.1 µm of the layer 17 after the detachment step of Figure 7 and prior to contact with said second support which could itself be definitive.

Finally, the layer 17 was released from the support 20 by means of a heat treatment at a temperature that exceeded the melting temperature of the wax. Cleaning using solvents could then be carried out to remove any wax residues remaining on the layer 17.

### EXAMPLE 5

Example 5 reproduces Example 2 and the implantation parameters of Example 4 with the following differences.

Firstly, the aim in this case was to produce strips of monocrystalline silicon at least 50 cm long transferred to plastic strips of the order of 5 cm wide.

To this end, the silicon ingot was cut longitudinally parallel to the X-X' axis, and lapped along this plane into a plurality of slabs in the form of rectangular parallelepipeds with a length of the order of 1.20 m, a thickness of the order of 1 cm and a width varying from about 305 mm to about 100 mm depending on whether the slabs were removed from the core of the ingot (close to the X-X' axis) or from the edges of the ingot.

Each of these slabs was implanted under conditions similar to Example 4 and underwent an annealing treatment at about 450°C.

Bonding was accomplished by applying an adhesive strip constituted by a plastic support strip onto which an adhesive had been spread.

Detachment was carried out by tearing said adhesive strip from the slab resulting from the ingot. For the same slab and in a single implantation step, it was then possible to remove a plurality of strip sections the width of which was defined by the width of the applied adhesive strip by juxtaposing a plurality of pieces of adhesive strip onto said wafer.

### EXAMPLE 6

Example 6 reproduces Example 3 with the following differences.

The aim of this example was to produce a finished substrate comprising a definitive plastic support 10 mm in diameter onto which a plurality of silicon chips have been transferred, each being hexagonal in shape.

A large quantity of such hexagons could be inscribed on the surface of a silicon ingot, depending on the diameter of the ingot, which can be 100 mm, 125 mm, 150 mm, 200 mm or even 300 mm.

The silicon ingot 10 considered here had a diameter of 100 mm.

After the step for implanting the front face 13 of the ingot, and heat treatment carried out at 450°C, a temporary support 20 is applied to said face 13.

This temporary support 20 was a tool provided with a hexagonal boss and a suction device that could create an underpressure at the boss to establish a temporary bond between said boss and a portion of the surface 13 of the ingot. This bond was temporary in that it could be interrupted by stopping the suction.

After starting the suction, the tool could remove a hexagonal silicon chip from the ingot by tearing. The tool could then transport said silicon hexagon and bring it into contact with the definitive support formed from plastic, already coated with adhesive for final assembly. Finally, the suction bond between the tool and the silicon hexagon was released.

The hexagon removal operation could then be repeated a plurality of times from face 13 of the ingot prior to having to finish the face of said ingot, for example by polishing. To this end, the dimensions of the hexagonal boss were such that it could advantageously remove a plurality of hexagonal chips side by side from each layer 17.

## Claims

1. A method of fabricating substrates (30), in particular for optics, electronics, or optoelectronics, by transferring a layer (170) of a material suitable for said type of application, and in particular a semiconductor material, onto a support (20), the method being **characterized in that** it comprises the following steps:
a) carrying out an operation for forming a flat face termed the "front face" (13) on a raw ingot (10) of material intended to form said layer (170), without - or substantially without - lapping the lateral surface (11) of said ingot;
b) implanting atomic species (2) beneath said front face (13) of said ingot (10) to a controlled mean implantation depth to create a zone of weakness (16) located close to said implantation depth and defining a top layer (17) of said ingot (10);
c) bonding a support (20) to said front face (13);
d) directly detaching from the ingot (10), at the zone of weakness (16), the portion (170) of said top layer (17) which is bonded to said support (20), to form said substrate (30); and re-commencing the cycle of said operations claims 2, 3 and 4 from step b) at least once.
e) re-commencing the cycle of said operations from step b) at least once.

2. A method according to claim 1, **characterized in that** the raw ingot (10) has the shape of a cylinder with an axis of revolution **X-X'** and **in that** the flat front face (13) is substantially perpendicular to said axis **X-X'**.

3. A method according to claim 1 or 2, **characterized in that** the support (20) has at least a portion of its outline (21) inscribed within the outline (14) of the front face (13) of the raw ingot (10).

4. A method according to claim 1 or 2, **characterized in that** the outline (21) of the face of the support (20) which comes into contact with the front face (13) of the raw ingot (10) is inscribed within the outline (14) of said front face (13).

5. A method according to any preceding claims, **characterized in that** it comprises a step of finishing the top layer (17) from which the portion (170) bonded to said support (20) has been removed, said finishing step being carried out occasionally after step d) and before recommencing step b) of a subsequent cycle of operations and consisting of eliminating the ring (170') of material of the top layer (17) that has not been transferred to the support (20), to obtain a new front face (13) that can be bonded to a new support (20)

6. A method according to anyone of claims 1 to 4, **characterized in that** it comprises a step of finishing the top layer (17) from which the portion (170) bonded to said support (20) has been removed, said finishing step being carried out systematically after step d) and before recommencing step b) of a subsequent cycle of operations and consisting of eliminating the ring (170') of material of the top layer (17) that has not been transferred to the support (20), to obtain a new front face (13) that can be bonded to a new support (20).

7. A method according to any preceding claims, **characterized in that** the operation of forming the front face (13) comprises an operation (1) for cutting and lapping the ingot (10).

8. A method according to any preceding claims, **characterized in that** the implantation operation (2) is carried out at high energy so that the portion (170) of the top layer (17) transferred onto said support (20) has sufficient thickness to be self-supporting.

9. A method according to any preceding claims, **characterized in that** said support (20) comprises at least one layer of a monocrystalline or polycrystalline material selected from silicon, silicon carbide, indium phosphide, gallium arsenide and germanium.

10. A method according to anyone of claims 1 to 8, **characterized in that** said support (20) is constituted by a plastic and/or flexible material.

11. A method according to anyone of claims 1 to 8, **characterized in that** said support (20) is a gripping tool.

12. A method according to anyone of claims 1 to 10, **characterized in that** the support (20) is bonded by molecular bonding.

13. A method according to anyone of claims 1 to 9, **characterized in that** the support (20) is bonded by eutectic bonding.

14. A method according to anyone of claims 1 to 10 **characterized in that** the support (20) is bonded by applying an adhesive.

15. A method according to anyone of claims 1 to 10, **characterized in that** the support (20) is bonded by applying a wax.

16. A method according to claim 11, **characterized in that** bonding is accomplished by applying electrostatic forces.

17. A method according to claim 11, **characterized in that** bonding is accomplished by applying a pressure differential.

18. A method according to anyone of claims 1 to 10 and 12 to 15, **characterized in that** the support (20) is definitively bonded.

19. A method according to anyone of claims 1 to 17, **characterized in that** the support (20) is temporary bonded.

20. A method according to any preceding claims, **characterized in that** the operation (3) for detaching the layer of material (170) from the remainder of the ingot (10) is carried out using at least one of the following techniques that can be used alone or in combination: applying stresses of mechanical or electrical origin, supplying heat energy, and a chemical etching operation.

21. A method according to any preceding claims, **characterized in that** the material of the ingot (10) is monocrystalline and is selected from silicon carbide, silicon, indium phosphide, gallium arsenide, and germanium.

22. A method according to any preceding claims, **characterized in that** said support (20) and/or said ingot (10) include (s) a layer of an insulator, in particular an oxide or a nitride.

23. A method according to any preceding claims, **characterized in that** during step a), said raw ingot is cut into at least one thick segment, said front face (13) being produced on said thick segment.

## Patentansprüche

1. Verfahren zur Herstellung von Substraten (30), insbesondere für die Optik, Elektronik oder Optoelektronik, durch die Übertragung einer Schicht (170) eines Materials, das für diesen Anwendungstyp geeignet ist, und insbesondere eines Halbleitermaterials, auf einen Träger (20), wobei das Verfahren **dadurch gekennzeichnet ist, daß** es folgende Schritte umfaßt:
(a) Ausführen eines Vorgangs zur Ausbildung einer flachen Fläche, die "Frontfläche" (13) genannt wird, auf einem Rohblock (10) eines Materials, das dafür vorgesehen ist, die Schicht (170) zu bilden, und dies ohne - oder im wesentlichen ohne - einem Läppen der Seitenfläche (11) des Blocks;
(b) Implantation von Atomsorten (2) unter der Frontfläche (13) des Blocks (10) auf einer kontrollierten mittleren Implantationstiefe zum Erzeugen einer Schwächungszone (16), die sich nahe bei der Implantationstiefe befindet und die eine obere Schicht (17) des Blocks (10) definiert;
(c) Bonden eines Trägers (20) auf die Frontfläche (13);
(d) direktes Ablösen vom Block (10), an der Schwächungszone (16), des Teils (170) der oberen Schicht (17), der an den Träger (20) gebondet ist, um das Substrat (30) zu bilden; und
(e) wenigstens einmaliges Wiederbeginnen des Zyklus der Vorgänge ab Schritt (b).

2. Verfahren nach Anspruch 1, **dadurch gekennzeichnet, daß** der Rohblock (10) die Form eines Zylinders hat, mit einer Rotationsachse X-X', und **dadurch**, daß die flache Frontseite (13) im wesentlichen senkrecht zur Achse X-X' ist.

3. Verfahren nach Anspruch 1 oder 2, **dadurch gekennzeichnet, daß** für den Träger (20) wenigstens ein Teil seines Umrisses (21) innerhalb des Umrisses (14) der Frontfläche (13) des Rohblocks (10) liegt.

4. Verfahren nach Anspruch 1 oder 2, **dadurch gekennzeichnet, daß** der Umriß (21) der Fläche des Trägers (20), die in Kontakt mit der Frontfläche (13) des Rohblocks (10) kommt, innerhalb des Umrisses (14) der Frontfläche (13) liegt.

5. Verfahren nach einem der vorhergehenden Ansprüche, **dadurch gekennzeichnet, daß** es einen Schritt zum Glätten der oberen Schicht (17) umfaßt, von der der an den Träger (20) gebondete Teil (170) entfernt wurde, wobei der Glättungsschritt gelegentlich nach Schritt (d) und vor dem Wiederbeginn von Schritt (b) eines nachfolgenden Vorgangszyklus ausgeführt wird und er darin besteht, den Materialring (170') der oberen Schicht (17) zu beseitigen, der nicht auf den Träger (20) übertragen wurde, um eine neue Frontfläche (13) zu erhalten, die auf einen neuen Träger (20) gebondet werden kann.

6. Verfahren nach einem der Ansprüche 1 bis 4, **dadurch gekennzeichnet, daß** es einen Schritt zum Glätten der oberen Schicht (17) umfaßt, von der der an den Träger (20) gebondete Teil (170) entfernt wurde, wobei der Glättungsschritt systematisch nach Schritt (d) und vor dem Wiederbeginn von Schritt (b) eines nachfolgenden Vorgangszyklus ausgeführt wird und er darin besteht, den Materialring (170') der oberen Schicht (17) zu beseitigen, der nicht auf den Träger (20) übertragen wurde, um eine neue Frontfläche (13) zu erhalten, die auf einen neuen Träger (20) gebondet werden kann.

7. Verfahren nach einem der vorhergehenden Ansprüche, **dadurch gekennzeichnet, daß** der Vorgang der Ausbildung der Frontfläche (13) einen Vorgang (1) zum Schneiden und Läppen des Blocks (10) umfaßt.

8. Verfahren nach einem der vorhergehenden Ansprüche, **dadurch gekennzeichnet, daß** der Implantationsvorgang (2) bei hoher Energie ausgeführt wird, so daß der Teil (170) der oberen Schicht (17), der auf den Träger (20) übertragen wird, eine ausreichende Dicke hat, um selbsttragend zu sein.

9. Verfahren nach einem der vorhergehenden Ansprüche, **dadurch gekennzeichnet, daß** der Träger (20) wenigstens eine Schicht eines monokristallinen oder polykristallinen Materials umfaßt, das aus den folgenden Materialien gewählt ist: Silizium, Siliziumkarbid, Indiumphosphid, Galliumarsenid und Germanium.

10. Verfahren nach einem der Ansprüche 1 bis 8, **dadurch gekennzeichnet, daß** der Träger (20) durch ein Kunststoffmaterial und/oder ein biegsames Material gebildet wird.

11. Verfahren nach einem der Ansprüche 1 bis 8, **dadurch gekennzeichnet, daß** der Träger (20) ein Greifwerkzeug ist.

12. Verfahren nach einem der Ansprüche 1 bis 10, **dadurch gekennzeichnet, daß** der Träger (20) durch molekulares Bonden gebondet wird.

13. Verfahren nach einem der Ansprüche 1 bis 9, **dadurch gekennzeichnet, daß** der Träger (20) durch eutektisches Bonden gebondet wird.

14. Verfahren nach einem der Ansprüche 1 bis 10, **dadurch gekennzeichnet, daß** der Träger (20) durch die Anwendung eines Klebstoffes gebondet wird.

15. Verfahren nach einem der Ansprüche 1 bis 10, **dadurch gekennzeichnet, daß** der Träger (20) durch die Anwendung eines Wachses gebondet wird.

16. Verfahren nach Anspruch 11, **dadurch gekennzeichnet, daß** das Bonden durch die Anwendung elektrostatischer Kräfte erreicht wird.

17. Verfahren nach Anspruch 11, **dadurch gekennzeichnet, daß** das Bonden durch die Anwendung eines Druckunterschieds erreicht wird.

18. Verfahren nach einem der Ansprüche 1 bis 10 und 12 bis 15, **dadurch gekennzeichnet, daß** der Träger (20) dauerhaft gebondet wird.

19. Verfahren nach einem der Ansprüche 1 bis 17, **dadurch gekennzeichnet, daß** der Träger (20) vorübergehend gebondet wird.

20. Verfahren nach einem der vorhergehenden Ansprüche, **dadurch gekennzeichnet, daß** der Vorgang (3) zum Ablösen der Materialschicht (170) vom Rest des Blocks (10) ausgeführt wird, indem wenigstens eine der folgenden Techniken verwendet wird, die alleine oder in Kombination angewendet werden können: Anwenden von Spannungen mechanischen oder elektrischen Ursprungs, Zuführen von Wärmeenergie und ein chemischer Ätzvorgang.

21. Verfahren nach einem der vorhergehenden Ansprüche, **dadurch gekennzeichnet, daß** das Material des Blocks (10) monokristallin ist und daß es aus den folgenden Materialien gewählt ist: Siliziumkarbid, Silizium, Indiumphosphid, Galliumarsenid und Germanium.

22. Verfahren nach einem der vorhergehenden Ansprüche, **dadurch gekennzeichnet, daß** der Träger (20) und/oder der Block (10) eine Schicht eines Nichtleiters umfassen, insbesondere einem Oxid order einem Nitrid.

23. Verfahren nach einem der vorhergehenden Ansprüche, **dadurch gekennzeichnet, daß** während Schritt (a) der Rohblock in wenigstens ein dickes Segment geschnitten wird, wobei die Frontfläche (13) auf dem dicken Segment hergestellt wird.

## Revendications

1. Procédé de fabrication de substrats (30), notamment pour l'optique, l'électronique ou l'optoélectronique, par transfert d'une couche (170) d'un matériau adapté à ce type d'application et notamment semi-conducteur, sur un support (20), **caractérisé par le fait qu'**il comprend les étapes consistant à :
a) soumettre un lingot brut (10) du matériau destiné à former ladite couche (170), à une opération de formation d'une face plane, dite "face avant" (13), sans effectuer -ou quasiment sans effectuer- de rectification de la surface latérale (11) de ce lingot,
b) implanter des espèces atomiques (2) sous ladite face avant (13) du lingot (10), à une profondeur moyenne d'implantation contrôlée, de façon à créer une zone de fragilisation (16), située au voisinage de cette profondeur d'implantation et délimitant une couche supérieure (17) dudit lingot (10),
c) coller sur ladite face avant (13), un support (20),
d) détacher directement du lingot (10), au niveau de la zone de fragilisation (16), la partie (170) de ladite couche supérieure (17) qui est collée audit support (20), de façon à former ledit substrat (30) et,
e) recommencer au moins une fois le cycle des opérations précédentes à partir de l'étape b).

2. Procédé selon la revendication 1, **caractérisé en ce que** le lingot brut (10) a la forme d'un cylindre d'axe de révolution X-X' et **en ce que** la face avant plane (13) est sensiblement perpendiculaire audit axe X-X'.

3. Procédé selon la revendication 1 ou 2, **caractérisé en ce que** le support (20) a au moins une partie de son contour (21) inscrite dans le contour (14) de la face avant (13) du lingot brut (10).

4. Procédé selon la revendication 1 ou 2, **caractérisé en ce que** le contour (21) de la face du support (20) qui vient au contact de la face avant (13) du lingot brut (10) est inscrit dans le contour (14) de ladite face avant (13).

5. Procédé selon l'une quelconque des revendications précédentes, **caractérisé en ce qu'**il comprend une étape de retouche de la couche supérieure (17) dont a été enlevée la partie (170) collée audit support (20), cette étape de retouche étant effectuée occasionnellement après l'étape d) et avant de recommencer l'étape b) d'un cycle ultérieur d'opérations et consistant à éliminer la couronne (170') de matériau de la couche supérieure (17) qui n'a pas été reportée sur le support (20), de façon à obtenir une nouvelle face avant (13) apte à être collée à un nouveau support (20).

6. Procédé selon l'une quelconque des revendications 1 à 4, **caractérisé en ce qu'**il comprend une étape de retouche de la couche supérieure (17) dont a été enlevée la partie (170) collée audit support (20), cette étape de retouche étant effectuée systématiquement après l'étape d) et avant de recommencer l'étape b) d'un cycle ultérieur d'opérations et consistant à éliminer la couronne (170') de matériau de la couche supérieure (17) qui n'a pas été reportée sur le support (20), de façon à obtenir une nouvelle face avant (13) apte à être collée à un nouveau support (20).

7. Procédé selon l'une quelconque des revendications précédentes, **caractérisé en ce que** l'opération de formation de la face avant (13) comprend une opération (1) de découpe et de rectification du lingot (10).

8. Procédé selon l'une quelconque des revendications précédentes, **caractérisé en ce que** l'opération d'implantation (2) est effectuée avec une forte énergie, de sorte que la partie (170) de la couche supérieure (17) reportée sur ledit support (20) présente une épaisseur suffisante pour être auto-portée.

9. Procédé selon l'une quelconque des revendications précédentes, **caractérisé en ce que** ledit support (20) comprend au moins une couche d'un matériau monocristallin ou polycristallin, choisi parmi le silicium, le carbure de silicium, le phosphure d'indium, l'arséniure de gallium et le germanium.

10. Procédé selon l'une quelconque des revendications 1 à 8, **caractérisé en ce que** ledit support (20) est constitué d'un matériau plastique et/ou souple.

11. Procédé selon l'une quelconque des revendications 1 à 8, **caractérisé en ce que** ledit support (20) est un outil de préhension.

12. Procédé selon l'une quelconque des revendications 1 à 10, **caractérisé en ce que** le collage du support (20) est effectué par adhésion moléculaire.

13. Procédé selon l'une quelconque des revendications 1 à 9, **caractérisé en ce que** le collage du support (20) est effectué par collage eutectique.

14. Procédé selon l'une quelconque des revendications 1 à 10, **caractérisé en ce que** le collage du support (20) est effectué par l'application d'un adhésif.

15. Procédé selon l'une quelconque des revendications 1 à 10, **caractérisé en ce que** le collage du support (20) est effectué par l'application d'une cire.

16. Procédé selon la revendication 11,
**caractérisé en ce que** le collage est effectué par application de forces électrostatiques.

17. Procédé selon la revendication 11, **caractérisé en ce que** le collage est effectué par application d'un différentiel de pression.

18. Procédé selon l'une quelconque des revendications 1 à 10 et 12 à 15, **caractérisé en ce que** le collage du support (20) est définitif.

19. Procédé selon l'une quelconque des revendications 1 à 17, **caractérisé en ce que** le collage du support (20) est temporaire.

20. Procédé selon l'une quelconque des revendications précédentes, **caractérisé en ce que** l'opération de détachement (3) de la couche de matériau (170), du reste du lingot (10) est effectuée par au moins l'une des techniques suivantes qui peuvent être utilisées seules ou de façon combinée parmi l'application de contraintes d'origine mécanique ou électrique, l'apport d'énergie thermique et une opération de gravure chimique.

21. Procédé selon l'une quelconque des revendications précédentes, **caractérisé en ce que** le matériau du lingot (10) est monocristallin et est choisi parmi le carbure de silicium, le silicium, le phosphure d'indium, l'arséniure de gallium et le germanium.

22. Procédé selon l'une quelconque des revendications précédentes, **caractérisé en ce que** ledit support (20) et/ou ledit lingot (10) comportent une couche d'isolant, notamment un oxyde ou un nitrure.

23. Procédé selon l'une quelconque des revendications précédentes, **caractérisé en ce qu'**au cours de l'étape a), ledit lingot brut (10) est découpé en au moins un tronçon épais, ladite face avant (13) étant ménagée sur ce tronçon épais.
